# EUROPÄISCHE PATENTANMELDUNG

(11) **EP 1 128 429 A1**
(43) Veröffentlichungstag der Anmeldung: **29.08.2001**
(21) Anmeldenummer: 00103725.8
(22) Anmeldetag: 22.02.2000
(51) Int. Cl.: H01L 21/8249, H01L 21/331

(54) **Verfahren zur Herstellung von bipolaren Transistoren im BiCMOS-Verfahren**

(71) Anmelder: Infineon Technologies AG, 81541 München (DE)
(72) Erfinder: Müller, Karlheinz, 84478 Waldkraiburg (DE)
(74) Vertreter: Zedlitz, Peter, Dipl.-Inf.

(57) **Zusammenfassung**

Bei einem in einen BiCMOS integrierbaren Herstellungsverfahren für bipolare einzelpolisilizium-Transistoren wird durch eine Basiskontaktschicht (10) bis zu einem Kollektorbereich (2, 7) ein Emitterkontaktloch (13) ausgeätzt. Anschließend werden im Emitterkontaktloch (13) die Basisschicht (8) und der Emitter (15) ausgebildet.

## Beschreibung

Die Erfindung betrifft ein Verfahren zur Herstellung von in CMOS-Schaltungen integrierten bipolaren Transistoren.

Ein derartiges Verfahren ist aus der EP 0 381 071 A2 bekannt. Bei dem bekannten Verfahren wird zunächst ein Kollektorbereich und ein Basisbereich in einem Substrat ausgebildet. Anschließend wird auf das Substrat eine Oxidschicht aufgebracht, in der ein Emitterkontaktloch zur Aufnahme des Emitters ausgebildet wird, der aus Polysilizium hergestellt wird. Bei dem bekannten Verfahren handelt es sich somit um einen sogenannten Einzelpolysiliziumprozeß, der in einen BiCMOS-Prozeß integrierbar ist.

Ein Nachteil des bekannten Verfahrens ist der hohe äußere Basisbahnwiderstand zwischen dem Rand des Emitters und der äußeren Basis.

Ausgehend von diesem Stand der Technik liegt der Erfindung die Aufgabe zugrunde, ein in einen BiCMOS-Prozeß integrierbares Verfahren anzugeben, durch das bipolare Transistoren mit geringem äußeren Basisbahnwiderstand herstellbar sind.

Diese Aufgabe wird erfindungsgemäß durch ein Verfahren nach Anspruch 1 gelöst.

Der wesentliche Verfahrensschritt des Verfahrens gemäß der Erfindung ist das Ausbilden des Emitterkontaktlochs, das durch die Isolierschicht und die Basiskontaktschicht bis zum Kollektorbereich hinunterreicht. Denn bei der im Emitterloch ausgebildeten Basis ist der Abstand zwischen dem Rand des Emitters und der äußeren Basis nur wenig größer als die Breite eines Abstandstücks. Dies hat einen geringen äußeren Basisbahnwiderstand zur Folge.

Weitere zweckmäßige Ausgestaltungen sind Gegenstand der abhängigen Ansprüche.

Nachfolgend wird ein Ausführungsbeispiel der Erfindung anhand der beigefügten Zeichnungen erläutert. Es zeigen:
- Figur 1: einen Querschnitt durch einen im Einzelpolysilizium-Prozeß hergestellten bipolaren Transistor; und
- Figur 2 bis 7: Querschnitte durch die Emitterzone des bipolaren Transistors aus Figur 1 nach verschiedenen Verfahrensschritten.

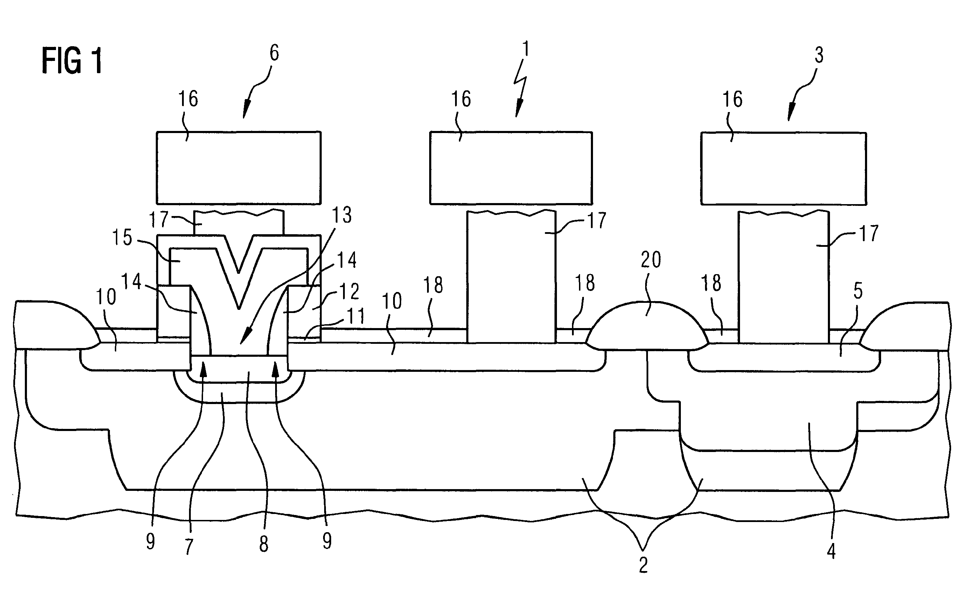

Der in Figur 1 dargestellte, in einem BiCMOS hergestellte bipolare Transistor 1 weist einen n-dotierten Kollektorbereich 2 auf. Es sei angemerkt, daß nachfolgend die Erfindung anhand des bipolaren npn-Transistors 1 erläutert wird. Die nachfolgenden Ausführungen gelten jedoch ohne Einschränkung ebenso für bipolare pnp-Transistoren.

Der Kollektorbereich 2 umfaßt in einer Kontaktzone 3 eine etwas höher als der übrige Kollektorbereich 2 n-dotierte Wanne 4 auf. An die Wanne 4 schließt sich ein n⁺-dotierter Kollektorbereich 5 an.

In einem Emitterkontaktbereich 6 umfaßt der Kollektorbereich 2 einen sogenannten Podest-Kollektor 7. Ein derartiger Podest-Kollektor 7 wird häufig auch als SIC ("Selectively Implanted Collector") bezeichnet. An den Podest-Kollektor 7 schließt sich eine Basisschicht 8 an, die in einem äußeren Bereich 9 an einer Basiskontaktschicht 10 anliegt. Die Basiskontaktschicht 10 ist im Emitterkontaktbereich 6 von einer ersten Isolierschicht 11 und einer zweiten Isolierschicht 12 abgedeckt, in denen oberhalb der Basisschicht 8 ein Emitterkontaktloch 13 ausgebildet ist. Seitlich im Emitterkontaktloch 13 sind Abstandsstücke 14 vorhanden, die eine in das Emitterkontaktloch 13 eingebrachte Emitterschicht 15 seitlich begrenzen. Um die Emitterschicht 15, die Basiskontaktschicht 10 und den Kollektorkontaktbereich 5 an zu Leiterbahnen 16 führende Vias 17 anzuschließen, sind niederohmige Kontaktschichten 18 vorgesehen.

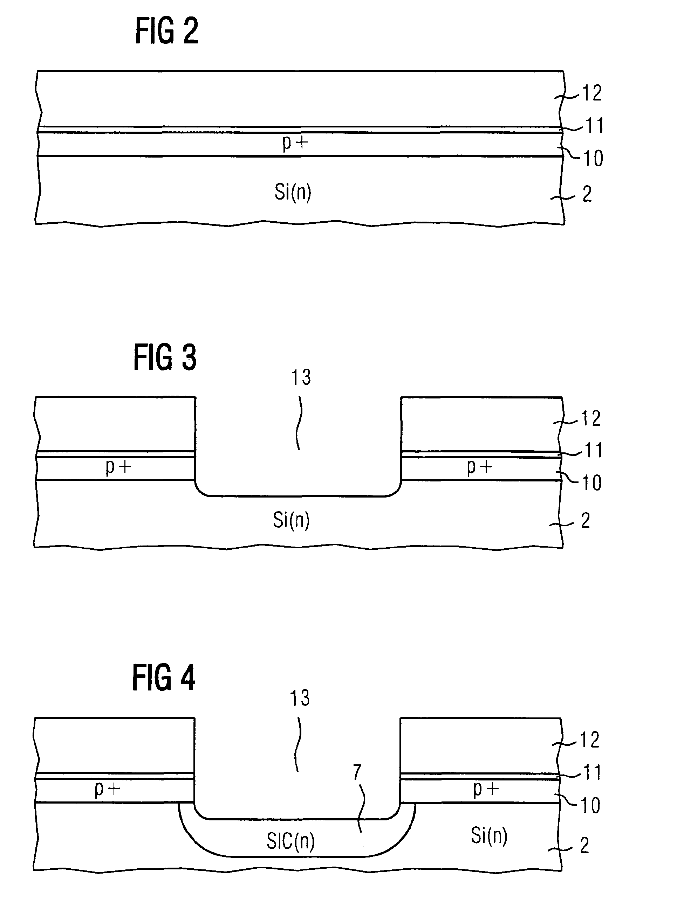

Nachfolgend wird ein selbstjustierendes Verfahren anhand der Figuren 2 bis 7 beschrieben. Der Übersichtlichkeit halber ist in den Figuren 2 bis 7 ausschließlich der Emitterkontaktbereich 6 dargestellt.

Zur Herstellung des bipolaren Transistors 1 wird zunächst oberhalb des Kollektorbereichs 2 eine p⁺ dotierte Basiskontaktschicht 10 unterhalb der ersten Isolierschicht 11 aus SiO₂ und der nachgeordneten zweiten Isolierschicht 12 aus Tetra-Ethyl-Ortho-Silikat ausgebildet. In einem BiCMOS-Prozeß entspricht die Basiskontaktschicht der Source-/Drain-Schicht eines PMOS-Transistors.

Anschließend wird, wie in Figur 3 dargestellt, das Emitterkontaktloch 13 ausgeätzt. In dem in Figur 3 dargestellten Fall erstreckt sich das Emitterkontaktloch 13 durch die erste und zweite Isolierschicht 11 und 12 hindurch bis in den Kollektorbereich 2. Das Emitterkontaktloch 13 muß sich nicht notwendigerweise bis in den Kollektorbereich 2 hinein erstrecken. Bei diesem Ausführungsbeispiel werden jedoch die erste Isolierschicht 11 und die zweite Isolierschicht 12 sowie die Basiskontaktschicht 10 vollständig ausgeätzt.

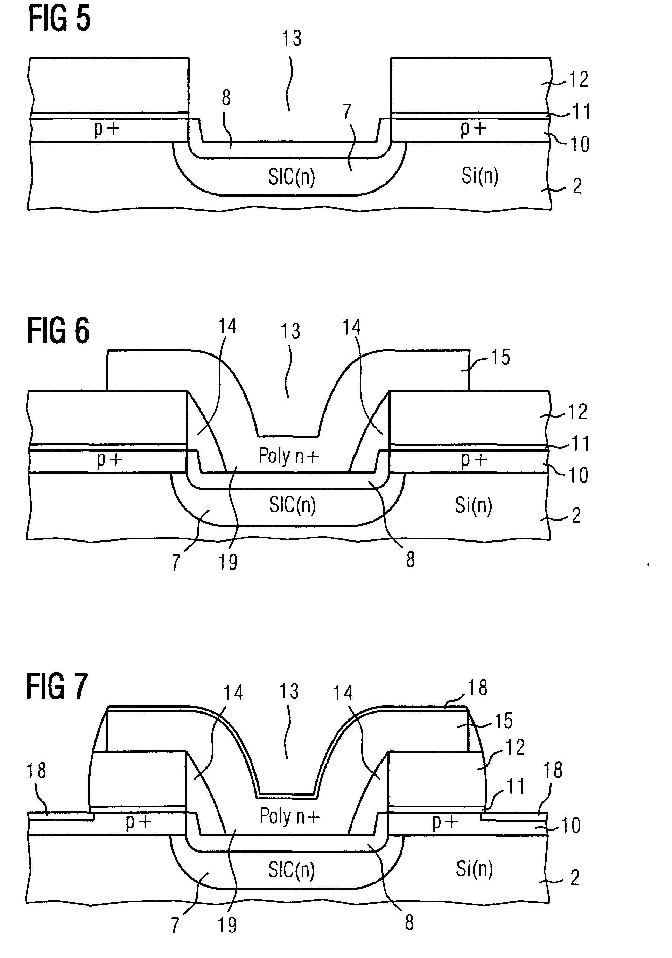

Nach dem Ausätzen des Emitterkontaktlochs 13 erfolgt die Implantation des n-dotierten Podest-Kollektors 7. Das Ergebnis dieses Verfahrensschritt ist in Figur 4 dargestellt. Durch Selektive Epitaxie wird anschließend gemäß Figur 5 die Basisschicht 8 im Emitterkontaktloch 13 abgeschieden. Dadurch entsteht eine Basisschicht 8, die im wesentlichen auf der gleichen Höhe wie die Basiskontaktschicht 10 liegt. Außerdem schließt die p-dotierte Basisschicht 8 unmittelbar an die p⁺-dotierte Basiskontaktschicht 10 an.

In einem nächsten Verfahrensschritt werden im Emitterkontaktloch 13 die Abstandsstücke 14 ausgebildet. Dabei handelt es sich zweckmäßigerweise um Abstandsstücke 14 aus einem Nitrid. Danach wird die Emitterschicht 15 im Emitterkontaktloch 13 und auf der zweiten Isolierschicht 12 hergestellt. Dadurch ergibt sich der in Figur 6 dargestellte Aufbau. Bei diesem Aufbau ist der Abstand zwischen einem Emitterrand 19 und dem Übergang zwischen der Basisschicht 8 und der Basiskontaktschicht 10 nur wenig größer als die Breite des Abstandstücks 14. Da außerdem die p-dotierte Basisschicht 8 unmittelbar an die p⁺-dotierte Basiskontaktschicht 10 anschließt, weist der bipolare Transistor 1 einen geringen äußeren Basisbahnwiderstand auf. Er eignet sich daher insbesondere für Hochfrequenzanwendungen.

Abschließend werden die erste Isolierschicht 11 und die zweite Isolierschicht 12 außerhalb des Emitterkontaktbereich 6 zurückgeätzt und die Kontaktschichten 18 aus Salizid aufgebracht. In weiteren Verfahrensschritten werden der Emitter 15, die Basiskontaktschicht 10 und der Kollektorkontaktbereich 5 über die Vias 17 an die Leiterbahnen 16 angeschlossen.

Bei einem abgewandelten Ausführungsbeispiel des Verfahrens wird die Basiskontaktschicht 10 nicht vollständig ausgeätzt. Falls in der Basiskontaktschicht 10 ein Dotierungsprofil mit zum Kollektorbereich 2 stark fallender Konzentration vorhanden ist, genügt es, die Basiskontaktschicht 10 soweit auszuätzen, daß die Konzentration der Dotieratome in der restlichen Basiskontaktschicht 10 der in der Basisschicht 8 üblichen Konzentration entspricht. Falls die Konzentration an Dotieratomen in der Basiskontaktschicht beispielsweise von 10²¹ cm⁻³ auf Werte unterhalb 10¹⁸ cm⁻³ fällt, wird in dem abgewandelten Verfahren der Bereich der Basiskontaktschicht 10 mit einer Konzentration an Dotieratomen oberhalb von 10¹⁸ cm⁻³ ausgeätzt. Auf die verbleibende Basiskontaktschicht 10 kann dann die Basisschicht 8 aufgebracht werden. Falls die verbleibende Basiskontaktschicht eine ausreichende Dicke aufweist, kann auf das Aufbringen der nachgeordneten Basisschicht 8 auch verzichtet werden.

Bei einem weiteren abgewandelten Verfahren wird die Basisschicht 8 nicht durch Selektive Epitaxie ausgebildet, sondern durch Implantation in die verbleibende Basiskontaktschicht 10 oder den Kollektorbereich 2.

Die hier vorgestellten Verfahren sind selbstjustierend und können in einen BiCMOS-Prozeß integriert werden.

## Patentansprüche

1. Verfahren zur Herstellung eine in eine CMOS-Schaltung integrierten bipolaren Transistors (1) mit folgenden Verfahrensschritten:
- Bereitstellen eines Kollektorbereichs (2, 7) in einem Substrat;
- Ausbilden einer nachgeordneten Basiskontaktschicht (10); mit darüberliegenden Isolierschicht (11, 12)
- Ausbilden eines sich durch die Isolierschicht (11, 12) zumindest bis in die Basiskontaktschicht (10) erstreckenden Emitterkontaktlochs (13);
- Herstellen einer Basisschicht (8) im Emitterkontaktloch (13) ;
- Ausbilden von Abstandsstücken (14) im Emitterkontaktloch (13); und
- Abscheiden einer Emitterschicht (15).

2. Verfahren nach Anspruch 1,
**dadurch gekennzeichnet,**
daß sich das Emitterkontaktloch (13) zumindest bis zum Kollektorbereich (2, 7) erstreckt.

3. Verfahren nach Anspruch 1 oder 2,
**dadurch gekennzeichnet,**
daß die Basisschicht (8) durch Selektive Epitaxie hergestellt wird.

4. Verfahren nach einem der Ansprüche 1 bis 3,
**dadurch gekennzeichnet,**
daß die Basisschicht (8) aus SiGe hergestellt wird.

5. Verfahren nach einem der Ansprüche 1 bis 4,
**dadurch gekennzeichnet,**
daß die Basiskontaktschicht (10) aus hochdotiertem Monosilizium hergestellt wird.

6. Verfahren nach einem der Ansprüche 1 bis 5,
**dadurch gekennzeichnet,**
daß im Kollektorbereich (2) ein Podest-Kollektor (7) ausgebildet wird.

7. Verfahren nach einem der Ansprüche 1 bis 6,
**dadurch gekennzeichnet,**
daß die Emitterschicht (15) aus dotiertem Polysilizium hergestellt wird.

8. Verfahren nach einem der Ansprüche 1 bis 7,
**dadurch gekennzeichnet,**
daß die Basiskontaktschicht (10) durch eine Schicht aus Siliziumoxid (11) überdeckt wird.
